# FASCICULE DE BREVET EUROPEEN

(11) **EP 0 331 998 B1**
(45) Date de publication et mention de la délivrance du brevet: **10.02.1993**
(21) Numéro de dépôt: 89103372.2
(22) Date de dépôt: 27.02.1989
(51) Int. Cl.: H01F 5/08, H01F 41/04, H01L 39/24

(54) **Conducteur assimilable à un bobinage, en matériau supraconducteur**
Leiter für eine Spule aus supraleitendem Material
Conductor suited for a coil of superconducting material

(30) Priorité: 07.03.1988 FR 8802851
(43) Date de publication de la demande: 13.09.1989
(73) Titulaire: GEC ALSTHOM SA, 75116 Paris (FR)
(72) Inventeur: Wicker, Alain, F-75013 Paris (FR); Fevrier, Alain, F-78310 Maurepas (FR)
(74) Mandataire: Weinmiller, Jürgen

(56) Documents cités:
- EP-A- 0 170 425
- FR-A- 2 035 162
- US-A- 3 561 111
- US-A- 4 494 100
- PATENT ABSTRACTS OF JAPAN vol. 8, no. 155 (E-256) 1592 19 juillet 1984, & JP-A-59 58803 (FUJIKURA DENSEN K.K.)
- ADVANCED CERAMIC MATERIALS vol. 2, no. 3B, juillet 1987, Westerville,OH,US; page 364 - 371; D.W.JOHNSON et al.: "fabrication of ceramic articles from high Tc superconducting oxides"
- PATENT ABSTRACTS OF JAPAN vol. 8, no. 29 (E-226) 1466 07 février 1984, & JP-A-58 191406 (ASAHI KASEI KOGYO K.K.)
- Japanese Journal of Applied Physics vol. 26, no. 7, juillet 1987, page 1172 - 1173; H.KUMAKURA et al.: "Ba-Y-Cu-O superconducting tape prepared by surface diffusion process"

## Description

La présente invention concerne un conducteur assimilable à un bobinage, en matériau supraconducteur.

On connaît des bobinages supraconducteurs réalisés avec des fils élaborés à partir de matériaux ductiles, en niobium-titane par exemple. Ces bobinages sont constitués d'enroulements, ce qui implique la possibilité de courber ces fils sans créer de discontinuités (rupture, fissure,...) en leur sein.

La découverte de nouveaux matériaux supraconducteurs à température critique élevée, 30 à 90 K au lieu de 8 à 15 K pour les alliages à base de niobium, permet d'envisager la réalisation de systèmes supraconducteurs fonctionnant à la température de l'azote liquide 77 K, au lieu de 4,2 K pour l'hélium liquide. Ces nouveaux matériaux sont des composés du type céramique : La Ba Cu O, La Sr Cu O, Y Ba Cu O. Comme toute céramique ces matériaux présentent un comportement fragile, c'est-à-dire que leur rupture s'effectue quasiment sans déformation. Il n'est donc pas aisé de réaliser des fils avec ces matériaux ; de plus, la déformation de tels fils sans rupture de la continuité électrique est très aléatoire.

La présente invention a notamment pour but de réaliser des conducteurs, assimilables à des bobinages, en matériau supraconducteur non ductile dont l'élaboration soit plus facile que celle des bobinages connus.

La présente invention a pour objet un conducteur assimilable à un bobinage en un matériau supraconducteur, caractérisé par le fait qu'il est réalisé à partir d'un élément massif en un oxyde supraconducteur fritté, ledit oxyde étant supraconducteur à température critique élevée, la forme dudit conducteur ayant été obtenue par usinage dudit élément massif et constituant une structure autoportante.

On entend par oxyde supraconducteur un matériau supraconducteur constitué d'une ou plusieurs phases de type oxyde.

Selon un premier exemple de réalisation, ledit élément massif a la forme d'un cylindre creux, ultérieurement découpé pour former un solénoïde.

Selon un second exemple de réalisation, ledit élément massif a la forme d'une plaque parallélépipédique ultérieurement découpée pour former une bobine plate.

Selon un troisième exemple de réalisation, ledit élément massif a la forme de deux demi-cylindres creux ultérieurement découpés pour former les deux parties d'un dipôle.

Ces exemples ne sont donnés qu'à titre illustratif.

Tout mode d'usinage approprié peut être utilisé : outillage mécanique de coupe, technique d'électro-érosion, usinage par laser....

D'autres caractéristiques et avantages de la présente invention apparaîtront au cours de la description suivante de divers conducteurs selon l'invention, description donnée à titre illustratif mais nullement limitatif.

Dans le dessin annexé :
- La figure 1 montre schématiquement en perspective un solénoïde selon l'invention,
- La figure 2 montre schématiquement en perspective une bobine plate selon l'invention,
- La figure 3 est une vue partielle schématique en perspective d'un élément appartenant à un dipôle selon l'invention
- La figure 4 est une vue de dessus développée de l'élément de la figure 3.

Afin de réaliser les variantes illustrées dans les figures, on part des matières premières suivantes : Y2O3, BaCO3, CuO, mélangées dans les proportions convenables ; on obtient après traitement thermique sous air à 1000°C le composé YBa2Cu3O7, dont la température critique est 91 K. Un tel procédé est décrit par exemple par M.K. Wu et al dans l'article paru dans Phys. Rev. Lett. 5B (1987) 90B.

On effectue sur la poudre obtenue un broyage en milieu liquide de façon à obtenir un diamètre médian de grain compris entre 0,5 et 2µm.

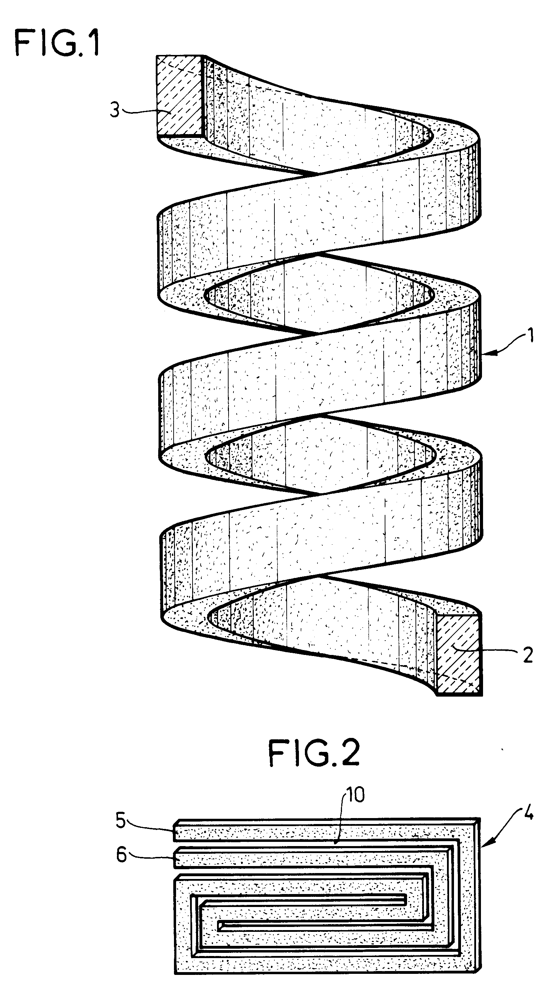

Pour obtenir le solénoïde 1 selon l'invention illustré à la figure 1, on prend de la poudre précédente et on réalise par compression isostatique, sous une pression de l'ordre de 2 tonnes par cm2, un cylindre dont les dimensions sont:
- diamètre extérieur : 38 mm
- diamètre intérieur : 30 mm
- longueur : 250 mm.
   Après un frittage sous oxygène à 970°C pendant une heure, on obtient un cylindre creux dont les éléments sont les suivants :
- diamètre extérieur : 32,6 mm
- diamètre intérieur : 25,5 mm
- longueur : 213 mm.

On découpe, à la scie diamantée circulaire par exemple, le cylindre selon une hélice 1 de pas tel que la largeur du ruban 3 soit de 14 mm de façon à avoir une section 2 d'environ 50 mm2 pour le passage du courant.

On obtient ainsi une structure autoportante comprenant dix à douze spires ; la longueur équivalente du conducteur obtenu est de l'ordre de 1 mètre.

Bien entendu le solénoïde décrit est une maquette de laboratoire. On peut envisager un modèle homothétique du précédent pour mettre en oeuvre dans des machines. On peut également prévoir un second solénoïde emboîté autour du premier.

Ces bobinages sont destinés à être mis en oeuvre notamment dans les prédisjoncteurs et les transformateurs.

Dans la figure 2 on voit une plaque 4 parallélépipédique obtenue par pressage uniaxial sous 4 tonnes par cm2 de la poudre d'oxyde définie plus haut. Cette plaque présente les dimensions suivantes :
24 x 12 x 0,6 mm.

Après frittage sous oxygène à 970°C pendant une heure, on obtient un carreau de dimensions 20,5 x 10,2 x 0,5 mm. En utilisant le fait que ce matériau est suffisamment conducteur à température ambiante, il est possible de découper cette plaque 4 à l'aide de la technique d'électro-érosion, suivant le tracé 10.

On obtient une bobine plate dont l'entrée et la sortie sont référencées 5 et 6, pratiquement aselfique. Là encore l'élément illustré est du type maquette de laboratoire. Une telle bobine peut s'appliquer industriellement dans le domaine de l'électronique de puissance, notamment comme valve de puissance.

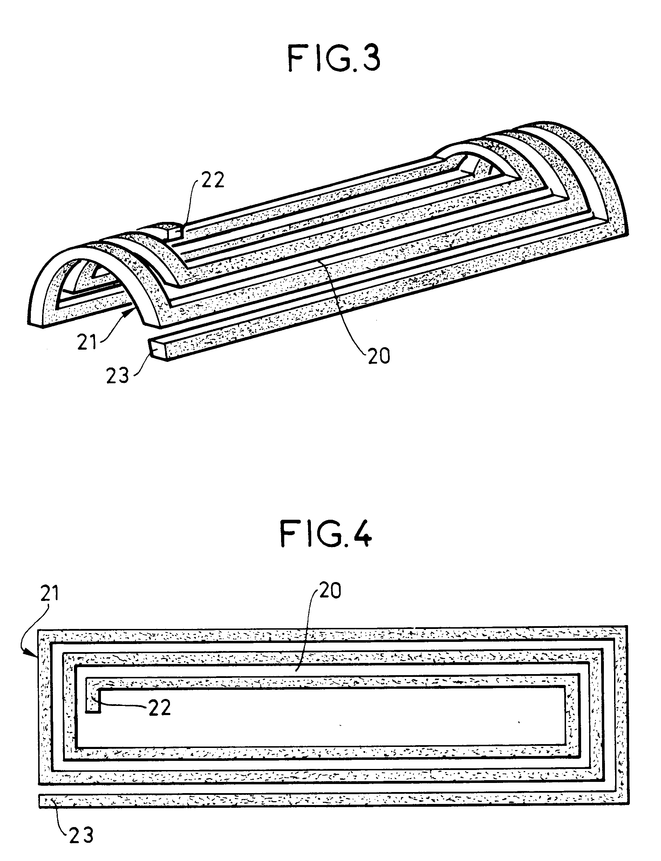

Dans les figures 3 et 4 on voit la moitié 21 d'un dipôle obtenu à partir d'un cylindre creux fritté en même matériau que les bobinages précédents. Une découpe à la scie diamantée par exemple par un plan passant par l'axe procure deux demi-cylindres. Chaque élément 21 est usiné par électro-érosion selon le tracé 20 visible plus nettement dans la figure 4 développée. L'entrée et la sortie du bobinage sont référencées 22 et 23.

Dans les deux éléments analogues du dipôle les sens de circulation du courant sont opposés l'un de l'autre.

De tels dipôles trouvent notamment des applications industrielles dans les inducteurs de machines.

## Revendications

1. Conducteur assimilable à un bobinage, en un matériau supraconducteur, caractérisé par le fait qu'il est réalisé à partir d'un élément massif en un oxyde supraconducteur fritté, ledit oxyde étant supraconducteur à température critique élevée, la forme dudit conducteur lui étant conférée par usinage dudit élément massif et constituant une structure autoportante.

2. Conducteur selon la revendication 1, caractérisé par le fait que ledit élément massif a la forme d'un cylindre creux, ultérieurement découpé pour former un solénoïde (1).

3. Conducteur selon la revendication 1, caractérisé par le fait que ledit élément massif a la forme d'une plaque parallélépipédique (4), ultérieurement découpée pour former une bobine plate.

4. Conducteur selon la revendication 1, caractérisé par le fait que ledit élément massif a la forme de deux demi-cylindres creux ultérieurement découpés pour former les deux parties (21) d'un dipôle.

5. Conducteur selon l'une des revendications précédentes caractérisé par le fait que ledit oxyde supraconducteur est choisi parmi les composés de type La Ba Cu O, La Sr Cu O, Y Ba Cu O.

## Claims

1. A conductor of superconducting material, susceptible to be assimilated to a coil, characterized in that it is made from a solid element of sintered superconducting oxide, said oxide having a high critical temperature, with the shape of said conductor being obtained by machining said solid element and constituting a self-supporting structure.

2. A conductor according to claim 1, characterized in that said solid element is in the form of a hollow cylinder which is subsequently cut to form a solenoid (1).

3. A conductor according to claim 1, characterized in that said solid element is in the shape of a rectangular plate (4) which is subsequently cut to form a flat coil.

4. A conductor according to claim 1, characterized in that said solid element is in the form of two hollow half-cylinders which are subsequently cut to form the two portions (21) of a dipole.

5. A conductor according to any preceding claim, characterized by the fact that said superconducting oxide is selected from compounds of the type: La Ba Cu O, La Sr Cu O and y Ba Cu O.

## Patentansprüche

1. Leiter aus supraleitendem Material, der einer Spule assimilierbar ist, dadurch gekennzeichnet, daß er aus einem massiven Element, bestehend aus einem gesinterten supraleitenden Oxid, hergestellt ist, wobei das Oxid bei erhöhter kritischer Temperatur supraleitend ist, die Form des Leiters durch spanende Bearbeitung des massiven Elementes erhalten wird und es eine selbsttragende Struktur bildet.

2. Leiter nach Anspruch 1, dadurch gekennzeichnet, daß das massive Element die Form eines hohlen Zylinders besitzt, der dann zur Bildung eines Solenoid (1) geschnitten wird.

3. Leiter nach Anspruch 1, dadurch gekennzeichnet, daß das massive Element die Form einer parallelepipedischen Platte (4) besitzt, die dann zur Bildung eines flachen Spule geschnitten wird.

4. Leiter nach Anspruch 1, dadurch gekennzeichnet, daß das massive Element die Form zweier hohler Halbzylinder besitzt, die dann zur Bildung der beiden Teile (21) eines Dipols geschnitten werden.

5. Leiter nach einem der vorhergehenden Ansprüche, dadurch gekennzeichnet, daß das supraleitende Oxid unter den Verbindungen des Typs La Ba Cu O, La Sr Cu O, Y Ba Cu O gewählt wird.
